# EUROPEAN PATENT SPECIFICATION

(11) **EP 4 425 086 B1**
(45) Date of publication and mention of the grant of the patent: **07.10.2026**
(21) Application number: 24153080.7
(22) Date of filing: 22.01.2024
(51) Int. Cl.: F28F 9/02, H05K 5/00, F28F 3/06, F28F 21/04, H05K 7/20, F28D 21/00, F28F 3/12

(54) **WATER-COOLING STRUCTURE**
WASSERKÜHLSTRUKTUR
STRUCTURE DE REFROIDISSEMENT PAR EAU

(30) Priority: 01.03.2023 TW 112107281
(43) Date of publication of application: 04.09.2024
(73) Proprietor: Pegatron Corporation, Taipei City 112 (TW)
(72) Inventor: LEE, Wei-Pang, 112 TAIPEI CITY (TW); SU, Shih-Chieh, 112 Taipei City (TW); CHOU, Shih-Kai, 112 Taipei City (TW)
(74) Representative: Becker, Eberhard

(56) References cited:
- CN-A- 111 918 520
- TW-B- I 765 606
- US-B2- 6 962 194
- US-B2- 7 213 638

## Description

### Technical Field

The invention relates to a device configured to dissipate heat; more particularly, the invention relates to a water-cooling structure.

### BACKGROUND

A water-cooling structure is an indispensable component in large machinery or automobiles. The conventional water-cooling structure typically incorporates a plurality of heat sink fins and establishes a unidirectional coolant flow path, thus facilitating a coolant to enter through an inlet and pass through the heat sink fins. During the flow process, the coolant and the heat sink fins exchange heat to reduce the temperature of the heat sink fins, and then the coolant passes through the heat sink fins and is discharged via an outlet.

However, most components of the conventional water-cooling structure are secured by screws, which results in intricate assembly procedures, substantial spatial requirements, and elevated production costs. In the conventional water-cooling structure, the internal heat sink fins and various ribs necessitate separate manufacturing and subsequent soldering steps. Inadequate soldering may easily introduce thermal resistance and detrimentally affect the heat dissipation efficiency.

Moreover, the configuration of the flow channels in the water-cooling structure is constrained by a stamping process, thereby hindering the ability to enhance the flow speed through diversion. Water-cooling structures according to the preamble of claim 1 are known from US 6 962 194 B2, CN 111 918 520 A and TW I 765 606 B.

### SUMMARY

The invention provides a water-cooling structure according to claim 1, with a plurality of integrally formed ribs to generate a plurality of flow channels. When a coolant flows in the water-cooling structure, the coolant is diverted by a plurality of flow channels, thereby increasing a flow speed of the coolant and the heat dissipation efficiency.

In an embodiment of the invention, a water-cooling structure includes a heat sink, a cover plate, a heat exchange module, a retaining wall, and a plurality of ribs. The heat sink has an inlet hole, an outlet hole, and an inner space. The inner space communicates with the inlet hole and the outlet hole. The cover plate is disposed on the heat sink to seal the inner space. The heat exchange module is disposed on the cover plate and located in the inner space. The retaining wall is disposed on the cover plate and located in the inner space, and the inlet hole and the outlet hole are disposed on different sides of the retaining wall. The ribs are disposed on the cover plate and located in the inner space to form a plurality of flow channels. A coolant enters the inner space from the inlet hole, enters the flow channels along the retaining wall to contact the heat exchange module, and flows out of the outlet hole after passing through the heat exchange module.

According to an embodiment of the invention, the heat exchange module, the retaining wall, and the ribs are all formed on the cover plate in a die-casting manner.

According to the invention, the heat exchange module has a first fin assembly and a second fin assembly respectively located on two sides of the retaining wall. According to an embodiment of the invention, the first fin assembly is positioned near the inlet hole, and the second fin assembly is positioned near the outlet hole.

According to an embodiment of the invention, the ribs are located on one of the two sides of the retaining wall near the outlet hole and connected to the second fin assembly.

According to an embodiment of the invention, the ribs are located on one of the two sides of the retaining wall near the inlet hole and connected to the first fin assembly.

According to an embodiment of the invention, the ribs are located on both the two sides of the retaining wall and respectively connected to the first fin assembly and the second fin assembly.

According to an embodiment of the invention, the number of the ribs includes two, so as to divide the flow channels into three flow channels.

According to an embodiment of the invention, the heat sink has a locking groove, and the cover plate is disposed in the locking groove.

According to an embodiment of the invention, the water-cooling structure further includes a first passage and a second passage that are disposed on a top surface of the heat sink and respectively communicate with the inlet hole and the outlet hole.

According to an embodiment of the invention, the heat sink and the cover plate are interconnected by soldering, riveting, or adhesion.

In light of the foregoing, the water-cooling structure provided in one or more embodiments of the invention is equipped with the integrally formed ribs on the cover plate to divide the inner space into the flow channels. When the coolant enters the inner space from the inlet hole, the coolant flows into the flow channels along the retaining wall. Therefore, the coolant is diverted by the flow channels. One part of the coolant is guided to a key heat dissipation region and stays for a longer time, thus enabling sufficient heat exchange between the coolant and the heat exchange module. The other part of the coolant quickly passes through the heat exchange module to avoid stagnation. The water-cooling structure provided in one or more embodiments of the invention adopts the design of a plurality of flow channels to optimize the flow speed and the heat dissipation efficiency.

To make the above more comprehensible, several embodiments accompanied with drawings are described in detail as follows.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1 is a schematic three-dimensional diagram of a water-cooling structure according to an embodiment of the invention.
FIG. 2 is a schematic three-dimensional diagram of the water-cooling structure in FIG. 1 in another direction.
FIG. 3 is a schematic exploded diagram of components of the water-cooling structure in FIG. 1.
FIG. 4 is a schematic exploded diagram of components of the water-cooling structure in FIG. 2.
FIG. 5 is a schematic perspective plane diagram of the water-cooling structure in FIG. 1.
FIG. 6 is a schematic perspective plane diagram of a water-cooling structure according to another embodiment of the invention.
FIG. 7 is a schematic perspective plane diagram of a water-cooling structure according to another embodiment of the invention.

### DESCRIPTION OF THE EMBODIMENTS

The embodiments of the invention are provided below for the purpose of clarity, and details for implementation are incorporated below. Moreover, wherever possible, elements/components/steps with the same reference numbers in the drawings and the embodiments denote the same or similar parts.

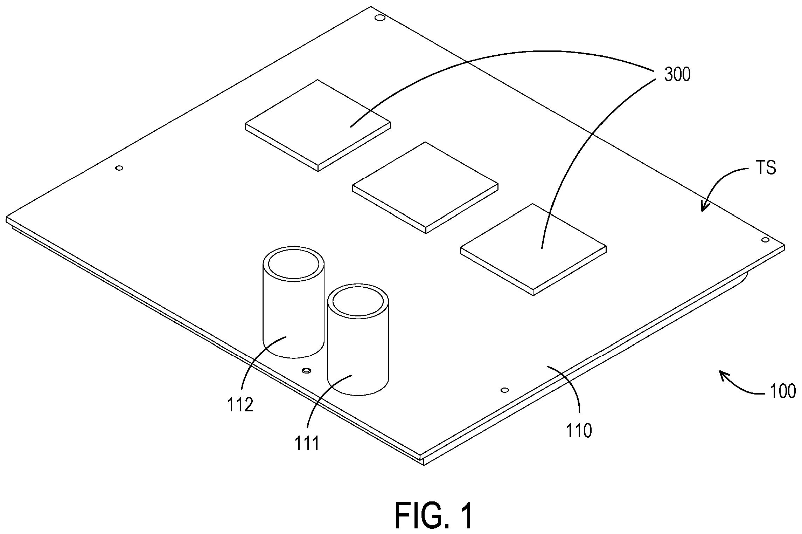

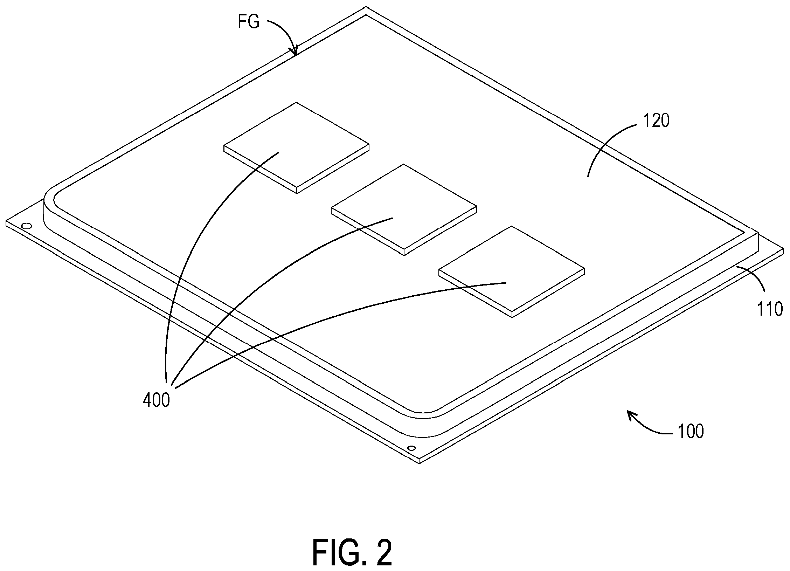

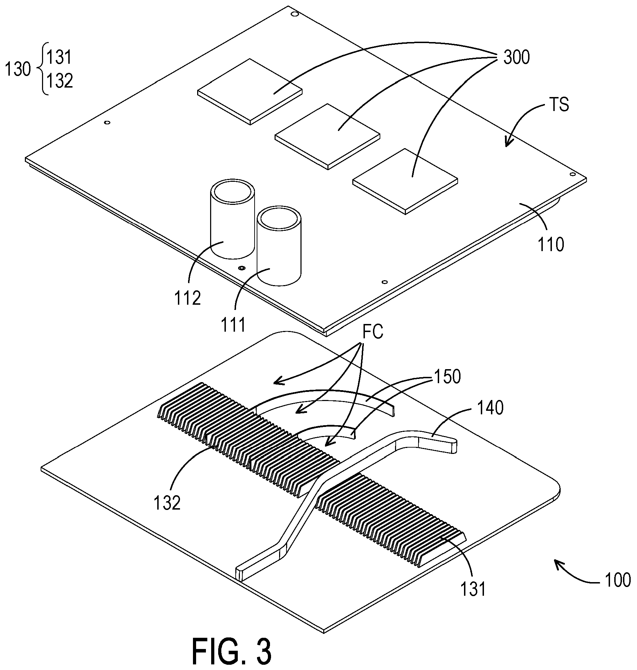

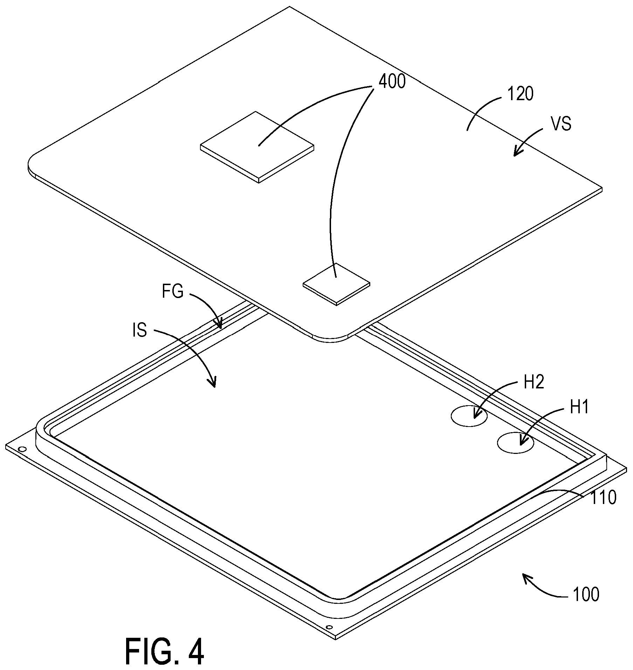

FIG. 1 is a schematic three-dimensional diagram of a water-cooling structure according to an embodiment of the invention. FIG. 2 is a schematic three-dimensional diagram of the water-cooling structure in FIG. 1 in another direction. FIG. 3 is a schematic exploded diagram of components of the water-cooling structure in FIG. 1. FIG. 4 is a schematic exploded diagram of components of the water-cooling structure in FIG. 2.

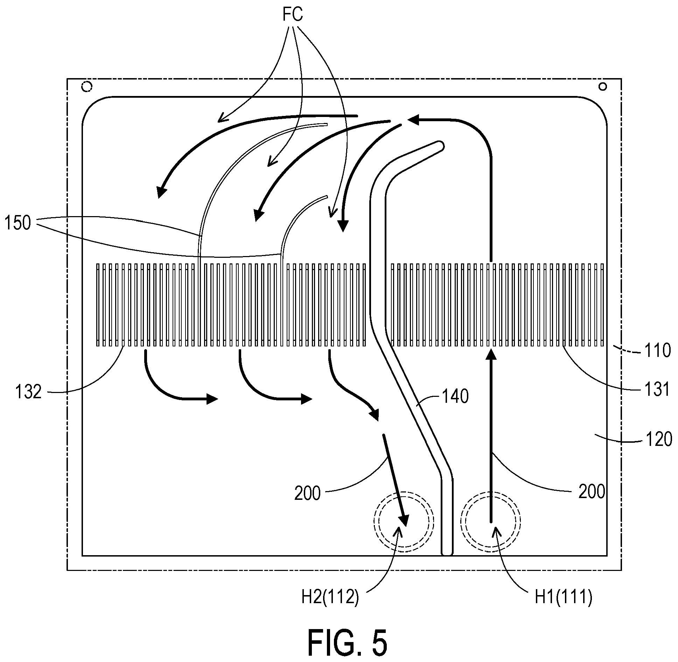

FIG. 5 is a schematic perspective plane diagram of the water-cooling structure in FIG. 1.

With reference to FIG. 1 and FIG. 2, a water-cooling structure 100 provided in an embodiment of the invention is applicable to large machinery or automobiles and is configured to contact a plurality of heat sources 300 and 400. Through heat conduction, the heat from the heat sources 300 and 400 is transferred to the water-cooling structure 100, and then heat exchange is performed between a circulating coolant and the water-cooling structure 100, so as to dissipate the heat and achieve heat dissipation. In addition, the water-cooling structure 100 is a sealed structure with an inner space, and the shape of the water-cooling structure 100 may be adjusted according to where the water-cooling structure 100 is placed.

With reference to FIG. 1 to FIG. 4, the water-cooling structure 100 provided in an embodiment of the invention includes a heat sink 110, a cover plate 120, a heat exchange module 130, a retaining wall 140, and a plurality of ribs 150.

The heat sink 110 has an inlet hole H1, an outlet hole H2, and an inner space IS. The inlet hole H1 and the outlet hole H2 penetrate a top surface TS of the heat sink 110, and the inner space IS is formed at the bottom of the heat sink 110 and communicates with the inlet hole H1 and the outlet hole H2. The cover plate 120 is disposed on the heat sink 110 to seal the inner space IS. In detail, the heat sink 110 and the cover plate 120 are interconnected by soldering, riveting, or adhesion, and the heat sink 110 has a locking groove FG. The cover plate 120 is disposed in the locking groove FG to seal the inner space IS.

The heat sink 110 and the cover plate 120 are made of metal or ceramic materials with high thermal conductivity. The heat exchange module 130 is disposed on the cover plate 120 and located in the inner space IS. The retaining wall 140 is disposed on the cover plate 120 and located in the inner space IS. With reference to FIG. 5, the inlet hole H1 and the outlet hole H2 are disposed on different sides of the retaining wall 140; that is, the retaining wall 140 is adapted to separate the inlet hole H1 and the outlet hole H2. The ribs 150 are disposed on the cover plate 120 and form a plurality of flow channels FC in the inner space IS.

In addition, the heat sink 110 further includes a first passage 111 and a second passage 112, which are vertically disposed on the top surface TS of the heat sink 110 and respectively communicate with the inlet hole H1 and the outlet hole H2. A coolant 200 is suitable for entering the inner space IS through the first passage 111 and the inlet hole H1, contacts the heat exchange module 130 through the flow channels FC, and flows out of the outlet hole H2 and the second passage 112 after passing through the heat exchange module 130. The next cooling cycle then continues.

With reference to FIG. 1 and FIG. 2, the top surface TS of the heat sink 110 is configured to contact the heat source 300, and a bottom surface of the cover plate 120, which is far from the inner space IS, is configured to contact the heat source 400. The water-cooling structure 100 further includes a plurality of support columns respectively disposed on the top surface TS of the heat sink 110 and the bottom surface of the cover plate 120. The support columns are located around the heat source 300 and the heat source 400 and configured to maintain a gap between the heat sink 110 or the cover plate 120 and machinery or automobile parts (not shown).

With reference to FIG. 3 and FIG. 4, the heat exchange module 130, the retaining wall 140, and the ribs 150 are all formed on the cover plate 120 in a die-casting manner. As such, it is no longer necessary to solder the heat exchange module 130, thus preventing the introduction of thermal resistance due to inappropriate soldering processes and thus detrimentally affecting the heat dissipation efficiency. In addition, the number and the guiding direction of the flow channels may be determined according to actual needs, and the retaining wall 140 and the ribs 150 may be integrally formed on the cover plate 120 through die-casting, so as to resolve the issue that the flow channels cannot be easily formed in the conventional water-cooling structure in a stamping process.

With reference to FIG. 3 and FIG. 5, particularly, the heat exchange module 130 has a first fin assembly 131 and a second fin assembly 132 respectively located on both sides of the retaining wall 140. The first fin assembly 131 is positioned near the inlet hole H1, and the second fin assembly 132 is positioned near the outlet hole H2. The ribs 150 are located on one of the two sides of the retaining wall 140 near the outlet hole H2 and connected to the second fin assembly 132; that is, the ribs 150 form a plurality of flow channels FC on one of the two sides of the outlet hole H2. In this embodiment, the number of the ribs 150 includes two, so as to divide the flow channels FC into three flow channels FC.

With reference to FIG. 1 and FIG. 5, a cooling process of the water-cooling structure 100 is described in detail below. The coolant 200 is introduced from the first passage 111 and enters the inner space IS of the heat sink 110 through the inlet hole H1. The coolant 200 flows and contacts the first fin assembly 131 and flows along the retaining wall 140 to the ribs 150, so that the coolant 200 is diverted and enters the flow channels FC. The diverted coolant 200 flows downward and contacts the second fin assembly 132, and the diverted coolant 200 converges after passing through and contacting the second fin assembly 132 and is discharged from the outlet hole H2 through the second passage 112.

When the coolant 200 passes through the flow channels FC, turbulent flows are generated due to the interference of the ribs 150, which slows down the flow speed of the coolant 200 in the flow channels FC. As such, the coolant 200 stays longer in the second fin assembly 132, so that the coolant 200 is able to sufficiently exchange heat with the second fin assembly 132.

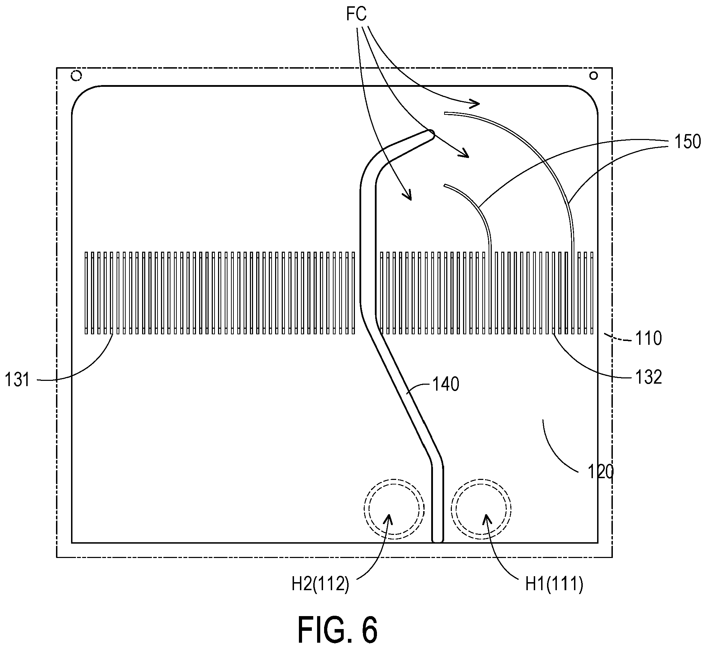

FIG. 6 is a schematic perspective plane diagram of a water-cooling structure according to another embodiment of the invention.

With reference to FIG. 6, in this embodiment, the ribs 150 are located on one side of the retaining wall 140 near the inlet hole H1 and connected to the first fin assembly 131. That is, the ribs 150 form the flow channels FC on the side near the inlet hole H1. When the coolant 200 enters the inner space IS from the inlet hole H1, the coolant 200 first passes through the first fin assembly 131 and then flows into the respective flow channels FC to achieve diversion. Afterwards, the coolant 200 converges and enters the other side of the retaining wall 140 to pass through the second fin assembly 132, and finally, the converged coolant 200 is discharged from the outlet hole H2, which explains that the heat source is located on the side of the retaining wall 140 near the inlet hole H1, and therefore the ribs 150 serve to reduce the flow speed of the coolant 200.

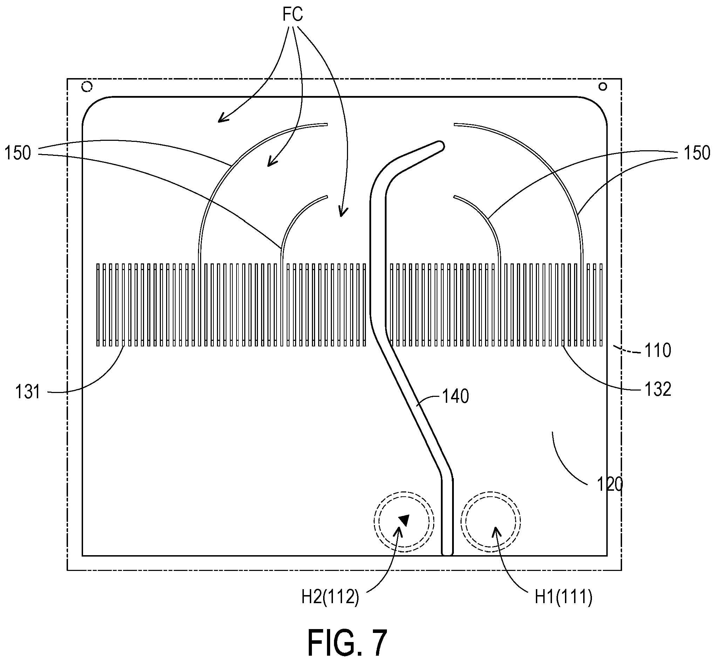

FIG. 7 is a schematic perspective plane diagram of a water-cooling structure according to another embodiment of the invention.

With reference to FIG. 7, in this embodiment, the ribs 150 are located on both sides of the retaining wall 140 and respectively connected to the first fin assembly 131 and the second fin assembly 132. That is, the ribs 150 form the flow channels FC on both sides of the retaining wall 140. When the coolant 200 enters the inner space IS from the inlet hole H1, the coolant 200 first passes through the first fin assembly 131 and then flows into the flow channels FC on the right side of the retaining wall 140 to achieve the diversion. Afterwards, the coolant 200 converges and enters the flow channels FC on the left side of the retaining wall 140, and the coolant 200 passes through the second fin assembly 132 through a secondary diversion. Finally, the coolant 200 passing through the second fin assembly 132 is discharged from the outlet hole H2, which explains that heat sources exist on both sides of the retaining wall 140, and through a two-stage diversion, the flow speed of the coolant 200 through the first fin assembly 131 and the second fin assembly 132.

To sum up, the water-cooling structure provided in one or more embodiments of the invention is equipped with the integrally formed ribs on the cover plate to divide the inner space into the flow channels. When the coolant enters the inner space from the inlet hole, the coolant flows into the flow channels along the retaining wall. Therefore, the coolant is diverted by the flow channels. One part of the coolant is guided to a key heat dissipation region and stays for a longer time, thus enabling sufficient heat exchange between the part of the coolant and the heat exchange module. The other part of the coolant quickly passes through the heat exchange module to avoid stagnation. The water-cooling structure provided in one or more embodiments of the invention adopts the design of a plurality of flow channels to optimize the flow speed and the heat dissipation efficiency.

## Claims

1. A water-cooling structure (100), comprising:
a heat sink (110), having an inlet hole (H1), an outlet hole, and an inner space, wherein the inner space communicates with the inlet hole (H1) and the outlet hole;
a cover plate (120), disposed on the heat sink (110) to seal the inner space;
a heat exchange module (130), disposed on the cover plate (120) and located in the inner space;
a retaining wall (140), disposed on the cover plate (120) and located in the inner space, wherein the inlet hole (H1) and the outlet hole are disposed on different sides of the retaining wall (140), wherein the retaining wall (140) separates the inlet hole (H1) and the outlet hole (H2), and the heat exchange module (130) has a first fin assembly (131) and a second fin assembly (132) respectively located on two sides of the retaining wall (140); and
a plurality of ribs (150), disposed on the cover plate (120) and located in the inner space to form a plurality of flow channels (FC),
wherein
a coolant (200) enters the inner space from the inlet hole (H1), enters the flow channels (FC) along the retaining wall (140) to contact the heat exchange module (130), and flows out of the outlet hole after passing through the heat exchange module (130), the water cooling structure (100) being **characterized in that** the plurality of ribs (150) are extended outside the first fin assembly (131), the second fin assembly (132) or both of the heat exchange module (130) and away from the inlet hole (H1) and the outlet hole (H2).

2. The water-cooling structure (100) as claimed in claim 1, wherein the heat exchange module (130), the retaining wall (140), and the ribs (150) are all formed on the cover plate (120) in a die-casting manner.

3. The water-cooling structure (100) as claimed in claim 1, wherein the first fin assembly (131) is positioned near the inlet hole (H1), and the second fin assembly (132) is positioned near the outlet hole.

4. The water-cooling structure (100) as claimed in claim 3, wherein the ribs (150) are located on one of the two sides of the retaining wall (140) near the outlet hole and connected to the second fin assembly (132).

5. The water-cooling structure (100) as claimed in claim 3, wherein the ribs (150) are located on one of the two sides of the retaining wall (140) near the inlet hole (H1) and connected to the first fin assembly (131).

6. The water-cooling structure (100) as claimed in claim 3, wherein the ribs (150) are located on both the two sides of the retaining wall (140) and respectively connected to the first fin assembly (131) and the second fin assembly (132).

7. The water-cooling structure (100) as claimed in either claim 4 or 5, wherein a number of ribs (150) includes two, so as to divide the flow channels (FC) into three flow channels (FC).

8. The water-cooling structure (100) as claimed in claim 1, wherein the heat sink (110) has a locking groove, and the cover plate (120) is disposed in the locking groove.

9. The water-cooling structure (100) as claimed in claim 1, further comprising a first passage (111) and a second passage (112) disposed on a top surface of the heat sink (110) and respectively communicating with the inlet hole (H1) and the outlet hole.

10. The water-cooling structure (100) as claimed in claim 1, wherein the heat sink (110) and the cover plate (120) are interconnected by soldering, riveting, or adhesion.

## Patentansprüche

1. Wasserkühlstruktur (100), umfassend:
einen Kühlkörper (110) mit einer Einlassöffnung (H1), einer Auslassöffnung und einem Innenraum, wobei der Innenraum mit der Einlassöffnung (H1) und der Auslassöffnung in Verbindung steht;
eine Abdeckplatte (120), die auf dem Kühlkörper (110) angeordnet ist, um den Innenraum abzudichten;
ein Wärmeaustauschmodul (130), das auf der Abdeckplatte (120) angeordnet ist und sich in dem Innenraum befindet;
eine Trennwand (140), die auf der Abdeckplatte (120) angeordnet ist und sich in dem Innenraum befindet, wobei die Einlassöffnung (H1) und die Auslassöffnung auf unterschiedlichen Seiten der Trennwand (140) angeordnet sind, wobei die Trennwand (140) die Einlassöffnung (H1) und die Auslassöffnung (H2) trennt, und das Wärmeaustauschmodul (130) eine erste Lamellenanordnung (131) und eine zweite Lamellenanordnung (132) aufweist, die sich jeweils an den beiden Seiten der Trennwand (140) befinden; und
eine Vielzahl von Rippen (150), die an der Abdeckplatte (120) angeordnet sind und sich in dem Innenraum befinden, um eine Vielzahl von Strömungskanälen (FC) zu bilden,
wobei ein Kühlmittel (200) von der Einlassöffnung (H1) in den Innenraum eintritt, entlang der Trennwand (140) in die Strömungskanäle (FC) eintritt, um mit dem Wärmeaustauschmodul (130) in Kontakt zu kommen, und nach dem Durchlaufen des Wärmeaustauschmoduls (130) aus der Auslassöffnung herausfließt,
wobei die Wasserkühlstruktur (100) **dadurch gekennzeichnet ist, dass** sich die Vielzahl von Rippen (150) außerhalb der ersten Lamellenanordnung (131), der zweiten Lamellenanordnung (132) oder beider Lamellenanordnungen des Wärmeaustauschmoduls (130) und von der Einlassöffnung (H1) und der Auslassöffnung (H2) weg erstrecken.

2. Wasserkühlstruktur (100) nach Anspruch 1, wobei das Wärmeaustauschmodul (130), die Trennwand (140) und die Rippen (150) alle in einem Druckgussverfahren auf der Abdeckplatte (120) gebildet sind.

3. Wasserkühlstruktur (100) nach Anspruch 1, wobei die erste Lamellenanordnung (131) in der Nähe der Einlassöffnung (H1) angeordnet ist und die zweite Lamellenanordnung (132) in der Nähe der Auslassöffnung angeordnet ist.

4. Wasserkühlstruktur (100) nach Anspruch 3, wobei sich die Rippen (150) auf einer der beiden Seiten der Trennwand (140) in der Nähe der Auslassöffnung befinden und mit der zweiten Lamellenanordnung (132) verbunden sind.

5. Wasserkühlstruktur (100) nach Anspruch 3, wobei sich die Rippen (150) an einer der beiden Seiten der Trennwand (140) in der Nähe der Einlassöffnung (H1) befinden und mit der ersten Lamellenanordnung (131) verbunden sind.

6. Wasserkühlstruktur (100) nach Anspruch 3, wobei sich die Rippen (150) auf beiden Seiten der Trennwand (140) befinden und mit der ersten Lamellenanordnung (131) bzw. der zweiten Lamellenanordnung (132) verbunden sind.

7. Wasserkühlstruktur (100) nach Anspruch 4 oder 5, wobei eine Anzahl von Rippen (150) zwei umfasst, um die Strömungskanäle (FC) in drei Strömungskanäle (FC) zu teilen.

8. Wasserkühlstruktur (100) nach Anspruch 1, wobei der Kühlkörper (110) eine Verriegelungsnut aufweist und die Abdeckplatte (120) in der Verriegelungsnut angeordnet ist.

9. Wasserkühlstruktur (100) nach Anspruch 1, ferner umfassend einen ersten Durchgang (111) und einen zweiten Durchgang (112), die an einer Oberseite des Kühlkörpers (110) angeordnet sind und mit der Einlassöffnung (H1) bzw. der Auslassöffnung in Verbindung stehen.

10. Wasserkühlstruktur (100) nach Anspruch 1, wobei der Kühlkörper (110) und die Abdeckplatte (120) durch Löten, Nieten oder Kleben miteinander verbunden sind.

## Revendications

1. Structure de refroidissement par eau (100), comprenant :
un dissipateur thermique (110), comportant un orifice d'entrée (H1),
un orifice de sortie et
un espace intérieur, ledit espace intérieur communiquant avec l'orifice d'entrée (H1) et l'orifice de sortie ;
une plaque de recouvrement (120), disposée sur le dissipateur thermique (110) afin de fermer hermétiquement l'espace intérieur ;
un module d'échange thermique (130), disposé sur la plaque de recouvrement (120) et situé dans l'espace intérieur ;
une paroi de retenue (140), disposée sur la plaque de recouvrement (120) et située dans l'espace intérieur, l'orifice d'entrée (H1) et l'orifice de sortie étant disposés de part et d'autre de la paroi de retenue (140), laquelle sépare l'orifice d'entrée (H1) et l'orifice de sortie (H2), et le module d'échange thermique (130) comporte un premier ensemble d'ailettes (131) et un deuxième ensemble d'ailettes (132) situés respectivement de part et d'autre de la paroi de retenue (140) ; et
une pluralité de nervures (150), disposées sur la plaque de recouvrement (120) et situées dans l'espace intérieur pour former une pluralité de canaux d'écoulement (FC),
dans lequel un fluide de refroidissement (200) pénètre dans l'espace intérieur par l'orifice d'entrée (H1), circule dans les canaux d'écoulement (FC) le long de la paroi de retenue (140) pour entrer en contact avec le module d'échange thermique (130), puis s'écoule hors de l'orifice de sortie après avoir traversé le module d'échange thermique (130),
dans lequel la structure de refroidissement par eau (100) étant **caractérisé en ce que** la pluralité de nervures (150) s'étend à l'extérieur du premier ensemble d'ailettes (131), du deuxième ensemble d'ailettes (132) ou à la fois du module d'échange thermique (130), et s'éloignent de l'orifice d'entrée (H1) et de l'orifice de sortie (H2).

2. Structure de refroidissement par eau (100) selon la revendication 1, dans laquelle le module d'échange thermique (130), la paroi de retenue (140) et les ailettes (150) sont tous formés sur la plaque de recouvrement (120) par moulage sous pression.

3. Structure de refroidissement par eau (100) selon la revendication 1, dans laquelle le premier ensemble d'ailettes (131) est positionné à proximité de l'orifice d'entrée (H1), et le deuxième ensemble d'ailettes (132) est positionné à proximité de l'orifice de sortie.

4. Structure de refroidissement par eau (100) selon la revendication 3, dans laquelle les nervures (150) sont situées sur l'un des deux côtés de la paroi de retenue (140) à proximité de l'orifice de sortie et reliées au deuxième ensemble d'ailettes (132).

5. Structure de refroidissement par eau (100) selon la revendication 3, dans laquelle les nervures (150) sont situées sur l'un des deux côtés de la paroi de retenue (140) à proximité de l'orifice d'entrée (H1) et sont reliées au premier ensemble d'ailettes (131).

6. Structure de refroidissement par eau (100) selon la revendication 3, dans laquelle les nervures (150) sont situées sur les deux côtés de la paroi de retenue (140) et sont respectivement reliées au premier ensemble d'ailettes (131) et au deuxième ensemble d'ailettes (132).

7. Structure de refroidissement par eau (100) selon la revendication 4 ou 5, dans laquelle le nombre de nervures (150) est de deux, de manière à diviser les canaux d'écoulement (FC) en trois canaux d'écoulement (FC).

8. Structure de refroidissement par eau (100) selon la revendication 1, dans laquelle le dissipateur thermique (110) comporte une rainure de verrouillage, et la plaque de recouvrement (120) est disposée dans la rainure de verrouillage.

9. Structure de refroidissement par eau (100) selon la revendication 1, comprenant en outre un premier passage (111) et un deuxième passage (112) disposés sur une surface supérieure du dissipateur thermique (110) et communiquant respectivement avec l'orifice d'entrée (H1) et l'orifice de sortie.

10. Structure de refroidissement par eau (100) selon la revendication 1, dans laquelle le dissipateur thermique (110) et la plaque de recouvrement (120) sont reliés entre eux par soudure, rivetage ou collage.
